# EUROPEAN PATENT APPLICATION

(11) **EP 2 645 578 A2**
(43) Date of publication of application: **02.10.2013**
(21) Application number: 12186067.0
(22) Date of filing: 26.09.2012
(51) Int. Cl.: H03M 7/30

(54) **Method, system and apparatus for data compression and decomression**

(30) Priority: 30.03.2012 JP 2012083183
(71) Applicant: FUJITSU LIMITED, Kawasaki-shi, Kanagawa 211-8588 (JP)
(72) Inventor: Unno, Hideyuki, Kanagawa, 211-8588 (JP)
(74) Representative: HOFFMANN EITLE

(57) **Abstract**

In a compression and decompression system that performs data compression and decompression, the decompression of compressed data is performed in a way that a compression apparatus (100) generates a byte code string as compressed data, and a decompression apparatus (200) executes the byte code string. The byte code includes an 8-byte-unit copy instruction and direct data processing instruction, and the compression apparatus (100) determines whether to use the 8-byte-unit copy instruction and direct data processing instruction or a byte-unit copy instruction and direct data processing instruction upon decompression, and generates the byte code.

## Description

### FIELD

The embodiments discussed herein are related to a compression and decompression system, a compression apparatus, a decompression apparatus, a compression and decompression method, a compression program, and a decompression program.

### BACKGROUND

In the past, as a data compression method, there has been LZ77 based on the repetition of code strings. In LZ77, a compression program searches whether a code string starting from a currently focused position has appeared before then. In a case where the code string has appeared, the compression program replaces the code string with the appearance position and the length of the code string. Herein, the range to search the code string is referred to as a slide window.

A slide window has a predetermined size, such as 8K bytes, 64K bytes, or the like, and is shifted on data with the progress of data compression processing. Therefore, compressed data is basically a list of a set of (copy start position in the slide window, copy length).

Also, a decompression program decompresses data by copying a code string of the copy length from the copy start position of the slide window, based on the set of (copy start position in the slide window, copy length).

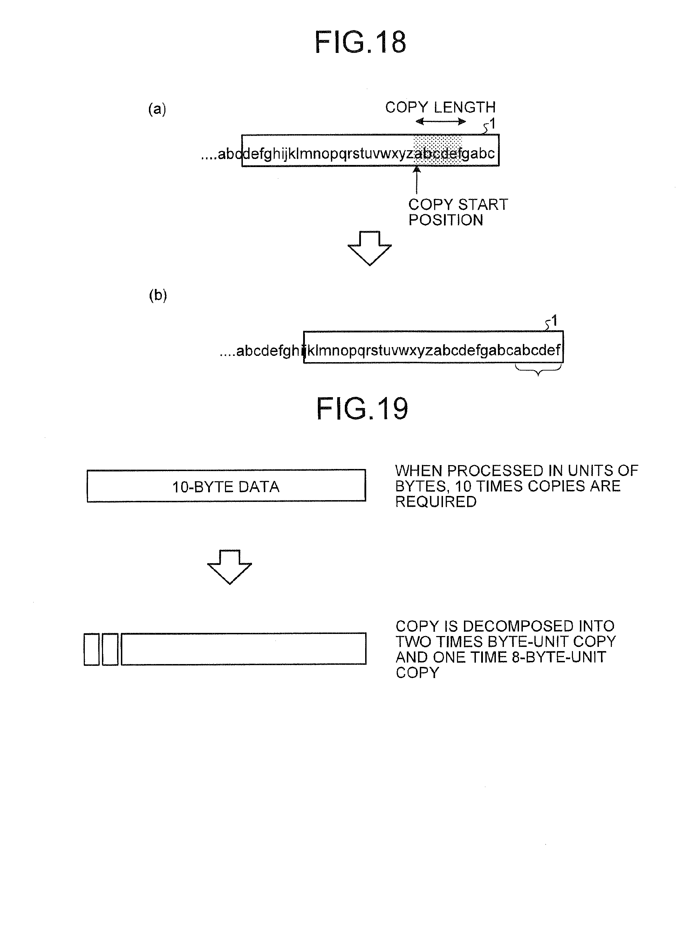

FIG. 18 is a diagram describing a decompression of LZ77 compressed data. When decompression is performed in a state of a slide window 1, a copy start position, and a copy length illustrated in FIG. 18(a), a character string "abcdef" of the copy length from the copy start position is copied to the tail end of the slide window 1 as illustrated in FIG. 18(b). Then, the slide window 1 is shifted by the copy length. The decompression processing of the LZ77 compressed data is basically the repetition of this processing.

Herein, processing necessary for each copy is as follows at a level of instructions that are processed by a computer.
(1) An address, which becomes a copy source, is computed based on a copy start position.
(2) An optimum copy processing is selected and executed according to a copy source address, a copy destination address, or a copy length.
(3) After the copy is executed, a slide window 1 is shifted. Also, as a related art, there is technology that allocates a converted address value having a small value at every 4 bytes in program data of a machine language by an RISC, because codes having the same meaning are stored in a predetermined area determined as a fixed format having a data length of 32 bits.

Patent Literature 1: Japanese Laid-open Patent Publication No. 2011-193406

In copy processing repeated in decompression processing of LZ77 compressed data, at a level of instructions processed by a computer, it is important to select and execute the optimum copy processing according to a copy source address, a copy destination address, and a copy length. That is, when the copy length is so short to the extent of several bytes, it is appropriate to repeat a byte-unit copy by necessary times. On the other hand, when the copy length is long, it is suitable that a fractional part is processed in units of bytes, and a part capable of being processed in units of 8 bytes is copied by using an 8-byte-unit load and store instruction.

FIG. 19 is a diagram illustrating an example of copy processing optimization. As illustrated in FIG. 19, in a case where the decompression program copies 10-byte data, when the data is copied in units of bytes, 10 times of copies are needed. On the other hand, when the decompression program decomposes the copy of 10-byte data into two times of the byte-unit copy and one time of the 8-byte-unit copy, only three times of the copies are needed.

However, in order to select the copy processing in detail as described above, branch processing based on an address and a copy length is required, and overhead of the branch processing disturbs the improvement of performance. That is, in pipeline processing, a computer predicts a branch direction with respect to a branch instruction, and speculatively executes a subsequent instruction. However, when there is a prediction error, the speculatively executed instruction needs to be discarded. Therefore, when there are a lot of branch instructions, the performance of the decompression program is degraded.

Accordingly, it is an object in one aspect of an embodiment of the invention to improve the performance of processing of decompressing compressed data.

### SUMMARY

According to an aspect of an embodiment, a compression and decompression system includes a compression apparatus that generates compressed data, which includes a code string capable of generating data by execution, based on the compressed data obtained by compressing the data, and has a small data amount with respect to the data; and a decompression apparatus that generates the data by executing the code string included in the compressed data.

### BRIEF DESCRIPTION OF DRAWINGS

FIG. 1 is a diagram illustrating a configuration of a compression and decompression system according to a first embodiment;
FIG. 2 is a diagram illustrating byte codes that are generated by a compression apparatus;
FIG. 3 is a diagram illustrating a configuration of a compression apparatus;
FIG. 4 is a flowchart illustrating a procedure of a compression processing by a compression apparatus;
FIG. 5 is a flowchart illustrating a procedure of a longest match search;
FIG. 6 is a flowchart illustrating a procedure of a retained direct data output;
FIG. 7 is a flowchart illustrating a procedure of a matched data string output;
FIG. 8 is a diagram illustrating an example of compressed data;
FIG. 9 is a diagram illustrating a configuration of a decompression apparatus;
FIG. 10 is a diagram illustrating a configuration of a computer used as a decompression apparatus;
FIG. 11 is a flowchart illustrating a processing of a computer in a case of writing 8-byte data to a main storage unit;
FIG. 12 is a diagram illustrating a functional configuration of a decompression program;
FIG. 13 is a diagram illustrating the number of times of load and store in an 8-byte-unit copy processing;
FIG. 14 is a flowchart illustrating a procedure of a decompression processing by a decompression program;
FIG. 15 is a flowchart illustrating a procedure of a copy processing;
FIG. 16 is a flowchart illustrating a procedure of a direct data processing;
FIG. 17 is a functional block diagram illustrating a configuration of a computer executing a compression program according to the embodiment;
FIG. 18 is a diagram describing a decompression of LZ77 compressed data; and
FIG. 19 is a diagram illustrating an example of a copy processing optimization.

### DESCRIPTION OF EMBODIMENTS

Preferred embodiments of the present invention will be explained with reference to accompanying drawings.

Also, this embodiment does not limit the disclosed technology.

### [a] First Embodiment

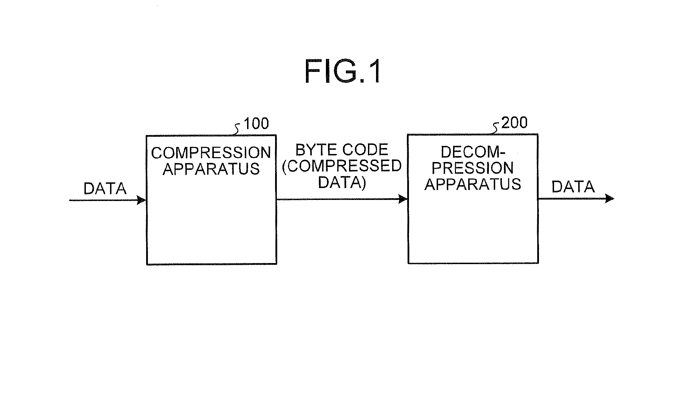

First, a compression and decompression system according to a first embodiment will be described. FIG. 1 is a diagram illustrating a configuration of a compression and decompression system according to a first embodiment. As illustrated in FIG. 1, the compression and decompression system includes a compression apparatus 100 and a decompression apparatus 200.

The compression apparatus 100 inputs and compresses data to generate compressed data. Herein, the compression apparatus 100 does not generate compressed data as a list of a set of (copy start position in a slide window, copy length), but generates compressed data as a byte code string. That is, the compression apparatus 100 generates compressed data by reading and compiling data to a byte code string.

The decompression apparatus 200 is a computer which generates original data from compressed data by executing a byte code string generated by the compression apparatus 100. That is, in the compression and decompression system according to the first embodiment, the decompression apparatus 200 decompresses compressed data by repeating a simple processing that executes a byte code.

On the contrary, the compression apparatus 100 generates optimum byte codes, such that the processing performance is improved at a level of instruction codes processed by a computer, in a copy processing repeated in the decompression process. Specifically, the compression apparatus 100 determines, upon compression, whether to use an 8-byte-unit instruction or a 1-byte-unit instruction upon decompression, and generates byte codes.

As described above, in the compression and decompression system according to the first embodiment, the compression apparatus 100 performs optimization in data compression at a level of instruction codes performed by a computer in decompression, such that the decompression processing is performed at a high speed. Therefore, the compression and decompression system according to the first embodiment increases processing amounts necessary for compression, but may speed up the processing in decompression.

Also, in FIG. 1, although the compression apparatus 100 and the decompression apparatus 200 are directly connected, the compression and decompression system according to the first embodiment stores compressed data, which is compressed by the compression apparatus 100, in a storage device (not illustrated), and decompresses compressed data, which is read from the storage device, by the decompression apparatus 200. Also, as illustrated in FIG. 1, the decompression apparatus 200 may directly input compressed data compressed by the compression apparatus 100, without passing through the storage device.

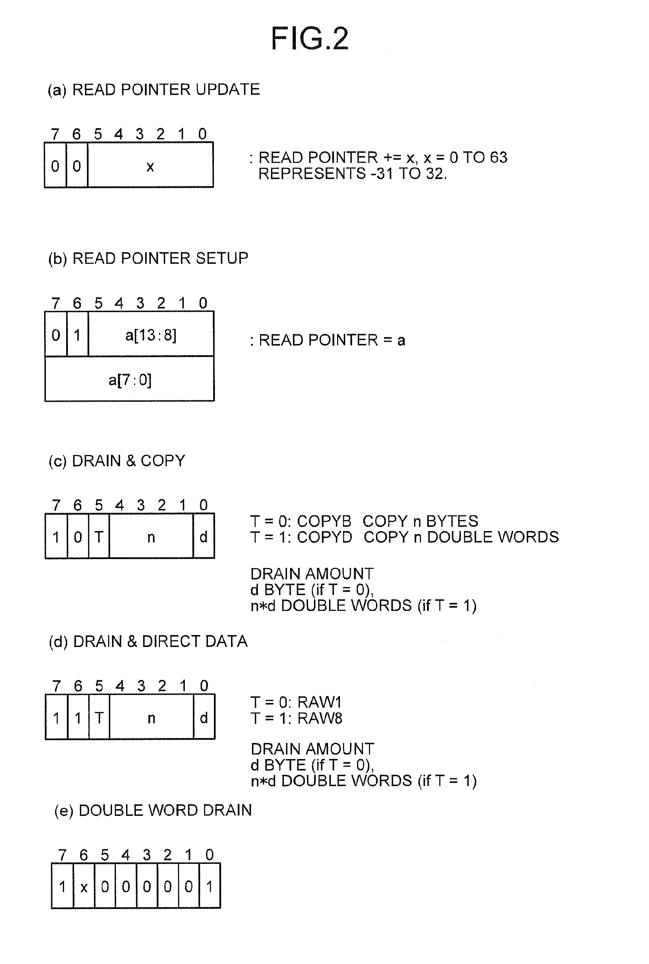

FIG. 2 is a diagram illustrating byte codes that are generated by the compression apparatus 100. As illustrated in FIG. 2, the byte codes includes a "read pointer update", a "read pointer setup", a "drain & copy", a "drain & direct data", and a "double word drain".

The "read pointer update" is an instruction that updates a read pointer by using bc[5:0] = x. Herein, the read pointer is a pointer that designates a start position of a code string of a copy source in the slide window 1. Also, bc[b2:b1] represents bit b1 to bit b2 of the byte code. For x = 0 to 63, the update value of the read pointer corresponds to -31 to 32. That is, the read pointer = the read pointer + x - 31. In the "read pointer update", bc[7:6] = 00.

The "read pointer setup" is a byte code having a length of 2 bytes, and bc[7:6] of the first byte = 01. The "read pointer setup" is an instruction that sets a[13:0] as the read pointer, a[13:0] having bc[5:0] of the first byte as upper 6 bits, and 8 bits of the second byte as lower 8 bits. That is, the read pointer = a[13:0].

Also, hereinafter, byte code "read pointer update" and byte code "read pointer setup" are collectively referred to as a "read pointer code".

The "drain & copy" is an instruction that instructs a data copy and drain in a slide buffer. Herein, the slide buffer is a buffer that stores data in the slide window 1. The copy source is designated by a read pointer, and the copy destination is designated by a write pointer. The write pointer indicates data next to data generated so far.

In the "drain & copy", be[7:6] = 10. Also, the "drain" is to drain a part of data from the head of the slide buffer to a memory. Data generated by the decompression processing are sequentially stored in the slide buffer, but data are drained from the head to the memory so as to prevent the slide buffer from overflowing.

bc[5] = T represents copy unit, T = 0 represents byte unit, and T = 1 represents double word unit. Herein, bc[b3] represents a bit b3 of a byte code. Also, the length of the double word is 8 bytes. bc[4:1] = n represents number of copy units. bc[0] = d represents a drain amount. In a case of T = 0, the drain amount is d bytes, and in a case of T = 1, the drain amount is n*d double words. Also, "*" represents multiplication.

Also, hereinafter, in the case of T = 0, byte code "drain & copy" will be referred to as a "COPYB code", and in the case of T = 1, byte code "drain & copy" will be referred to as a "COPYD code".

The "drain & direct data" is an instruction that instructs a direct data storage to the slide buffer and drain. The direct data is data subsequent to the byte code among the compressed data. A data storage destination is designated by the write pointer.

bc[5] = T represents direct data unit, T = 0 represents byte unit, and T = 1 represents double word unit. bc[4:1] = n represents number of data units. bc[0] = d represents a drain amount. In a case of T = 0, the drain amount is d bytes, and in a case of T = 1, the drain amount is n*d double words. In the "drain & direct data", bc[7:6] = 11. The "drain & direct data" is used when direct data is stored in a slide buffer in the beginning of the decompression processing, or the like.

Also, hereinafter, in the case of T = 0, byte code "drain & direct data" will be referred to as a "RAW1 code", and in the case of T = 1, byte code "drain & direct data" will be referred to as a "RAW8 code".

The "double word drain" is an instruction that instructs a drain of 1 double word. In the "double word drain", bc[7:0] = 1x000001. Also, "x" may be either 0 or 1.

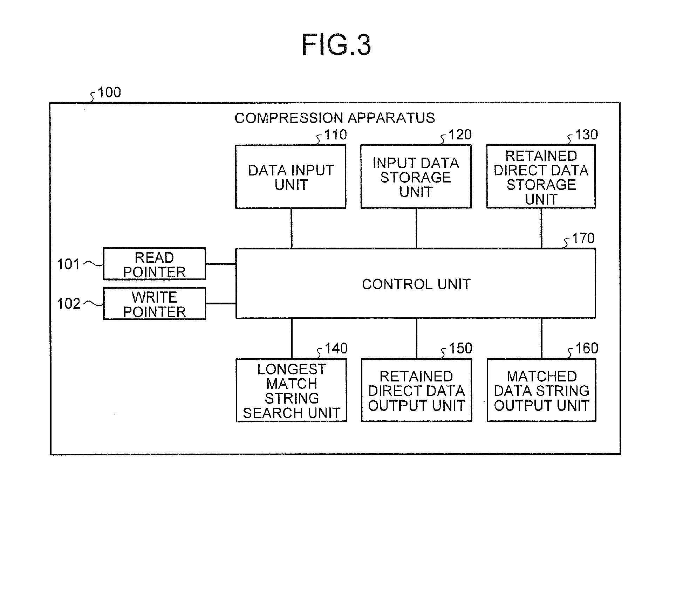

Next, the configuration of the compression apparatus 100 will be described. FIG. 3 is a diagram illustrating the configuration of the compression apparatus 100. As illustrated in FIG. 3, the compression apparatus 100 includes a read pointer 101, a write pointer 102, a data input unit 110, an input data storage unit 120, a retained direct data storage unit 130, a longest match string search unit 140, a retained direct data output unit 150, and a matched data string output unit 160. Also, the compression apparatus 100 includes a control unit 170.

The read pointer 101 stores a data read position from a slider buffer during decompression, and the write pointer 102 stores a data write position to a slide buffer during decompression.

The data input unit 110 reads data to be compressed from a file, and writes the read data to the input data storage unit 120. The input data storage unit 120 stores data to be compressed, and a part of the input data storage unit 120 is used as a slide buffer.

The retained direct data storage unit 130 stores data that becomes a part of a compression code as direct data (raw data) subsequent to a RAW1 code or a RAW8 code. That is, the retained direct data storage unit 130 stores a code string for which a matched code string is not searched in a slide buffer.

The longest match string search unit 140 searches for the longest code string, among code strings matched with the code string to be compressed at a certain time point by the compression apparatus 100, as the longest match code string from the slide buffer.

The retained direct data output unit 150 outputs the RAW1 code or the RAW8 code to the file, and outputs direct data, which is stored by the retained direct data storage unit 130, to a file as direct data subsequent to the RAW1 code or the RAW8 code.

The matched data string output unit 160 outputs a byte code, which copies the longest match code string searched by the longest match string search unit 140, to a file. Also, when there is a difference between a start position of the longest match code string in the slide buffer and a current value of the read pointer 101, the matched data string output unit 160 outputs a read pointer instruction to a file and adjusts a value of the read pointer 101 to the start position of the longest match code string in decompression.

The control unit 170 performs an overall control of the compression apparatus 100. Specifically, the control unit 170 enables the compression apparatus 100 to function as a single device by performing a shift of control between the functional units, or delivering and receiving data between the functional unit and the storage unit.

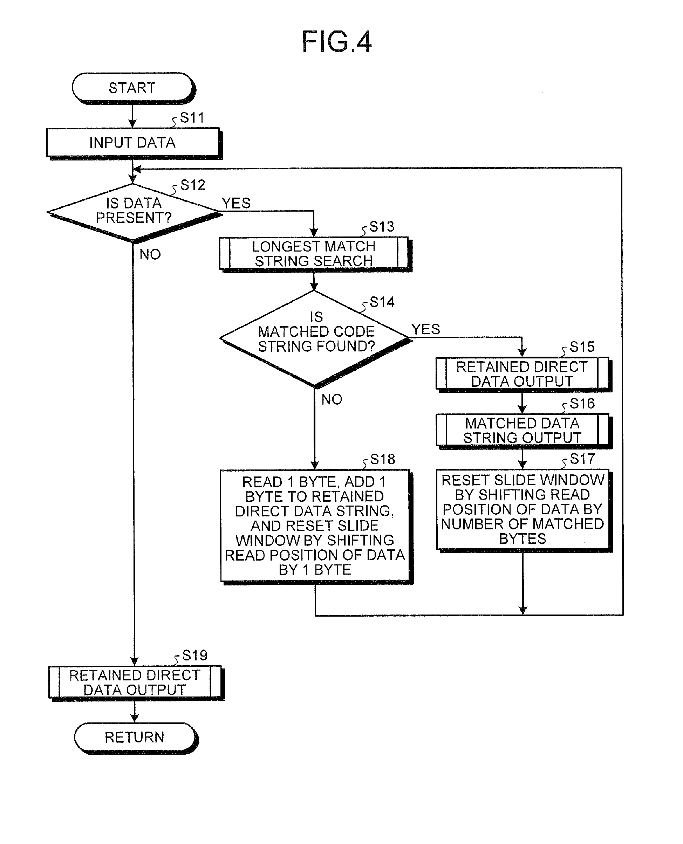

Next, the procedure of the compression processing by the compression apparatus 100 will be described. FIG. 4 is a flowchart illustrating the procedure of the compression processing by the compression apparatus 100. As illustrated in FIG. 4, in the compression apparatus 100, the data input unit 110 inputs data to be compressed from a file (step S11), and writes the input data to the input data storage unit 120.

Then, the control unit 170 reads data from the input data storage unit 120, and determines a presence or absence of data (step S12). As a result, when the data is present, the longest match string search unit 140 performs a longest match string search (step S13). That is, the longest match string search unit 140 searches the longest code string, which matches with the code string to be compressed, from the slide buffer.

Then, the control unit 170 determines whether or not the matched code string is found (step S14). When the matched code string is found, the retained direct data output unit 150 performs a retained direct data output (step S15). That is, the retained direct data output unit 150 outputs a RAW1 code or a RAW8 code, and outputs direct data, which is stored by the retained direct data storage unit 130, as direct data subsequent to the RAW1 code or the RAW8 code. Then, the matched data string output unit 160 performs a matched data string output (step S16). That is, the matched data string output unit 160 outputs a byte code, which copies the longest match code string searched by the longest match string search unit 140. Then, the control unit 170 resets the slide window by shifting a read position from the input data storage unit 120 by the number of matched bytes (step S17). Then, the control unit 170 returns the control to step S12.

On the other hand, when the matched code string is not found, the control unit 170 reads 1 byte from the input data storage unit 120, and adds the read byte to the retained direct data storage unit 130. Also, the control unit 170 resets the slide window by shifting a read position from the input data storage unit 120 by 1 byte (step S18). The control unit 170 returns the control to step S12.

On the other hand, when data is absent in the input data storage unit 120, the retained direct data output unit 150 performs a retained direct data output (step S19), and the control unit 170 ends the compression processing.

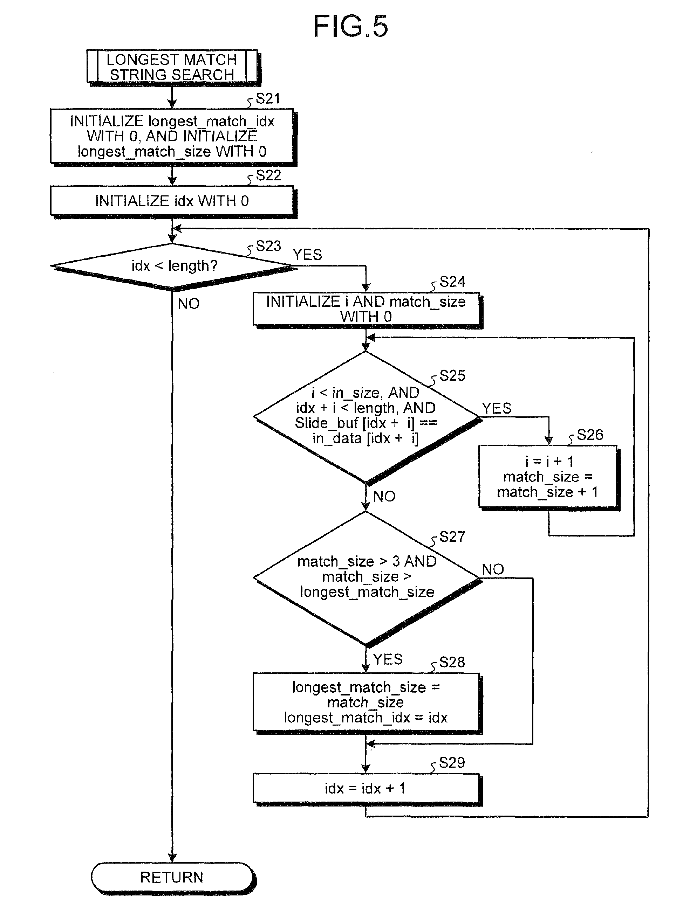

Next, the procedure of the longest match string search will be described. FIG. 5 is a flowchart illustrating the procedure of the longest match string search. As illustrated in FIG. 5, the longest match string search unit 140 initializes longest_match_idx and longest_match_size with 0 (step S21). Herein, longest_match_idx is a start position of the longest matched code string in the slide buffer, and longest_match_size is a length of the longest matched code string.

The longest match string search unit 140 initializes idx with 0 (step S22). Herein, idx represents a head position of a code string searched within the slide buffer. Then, the longest match string search unit 140 determines whether or not idx is less than the length (step S23). Herein, the length is a size of the slide buffer.

When idx is not less than the length, the search of the slide buffer is ended. Therefore, the longest match string search unit 140 ends the processing and returns longest_match_idx and longest_match_size as the search result.

On the other hand, when idx is less than the length, the longest match string search unit 140 initializes i and match_size with 0 (step S24). Herein, i is an offset from the head of the code string being searched within the slide buffer, and match_size is a length of a code string has matched so far.

Then, the longest match string search unit 140 determines whether i is less than in_size, and idx + i is less than the length, and Slide_buf[idx + i] and in_data[idx + i] are equal to each other (step S25). Herein, in_size is a length of uncompressed data, Slide_buf is the slide buffer, and in_data is an uncompressed portion of the input data storage unit 120.

As a result, when i is less than in_size, idx + i is less than the length, and Slide_buf[idx + i] and in_data[idx + i] are equal to each other, the longest match string search unit 140 adds 1 to i and match_size (step S26) and returns to step S25. Herein, the case where i is less than in_size, idx + i is less than the length, and Slide_buf[idx + i] and in_data[idx + i] are equal to each other is a case where the code strings being currently searched within the slide buffer are matched with the uncompressed code strings till (i + 1)th code string.

On the other hand, when the determination in step S25 is false, the longest match string search unit 140 determines whether match_size is greater than 3 and match_size is greater than longest_match_size (step S27). Herein, the case where the result in step S25 is No is a case where the (i + 1)th code string being currently searched within the slide buffer is not matched with (i + 1)th uncompressed code string.

As a result, when match_size is greater than 3 and match_size is greater than longest_match_size, the longest match string search unit 140 sets match_size as a new value of longest_match_size, and sets idx as a new value of longest_match_idx (step S28). Herein, the case where match_size is greater than 3 and the match_size is greater than longest_match_size is a case where a longest match code string is newly found. Then, the longest match string search unit 140 adds 1 to idx (step S29), and returns to step S23 to search a new longest match code string from a position shifted by 1 within the slide buffer.

On the other hand, when match_size is not greater than 3, or match_size is not greater than longest_match_size, the longest match string search unit 140 adds 1 to idx (step S29) and returns to step S23. Herein, the case where match_size is not greater than 3, or match_size is not greater than longest_match_size is a case where the length of the matched code string is equal to or less than 3, or is shorter than the longest match code strings searched so far.

In this way, since the longest match string search unit 140 searches for the longest matched code string from the slide buffer, the compression apparatus 100 may compress the repeated code string with high efficiency.

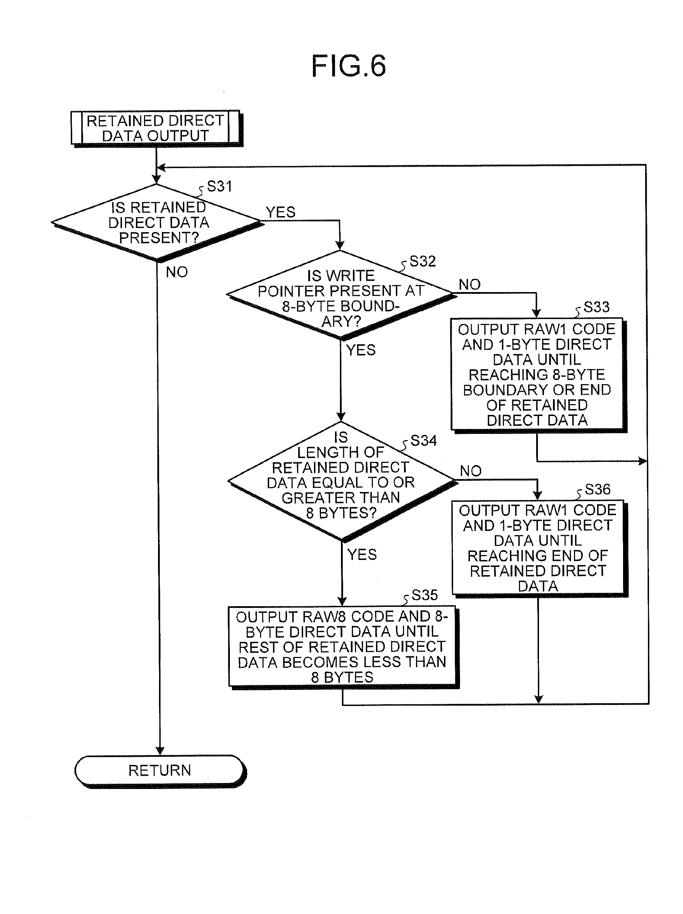

Next, the procedure of the retained direct data output will be described. FIG. 6 is a flowchart illustrating the procedure of the retained direct data output. As illustrated in FIG. 6, the retained direct data output unit 150 determines whether or not retained direct data is present in the retained direct data storage unit 130 (step S31). As a result, when the retained direct data is not present, the retained direct data output unit 150 ends the processing.

On the other hand, when the retained direct data is present, the retained direct data output unit 150 determines whether or not the write pointer 102 is present at an 8-byte boundary (step S32). As a result, when the write pointer 102 is not present at the 8-byte boundary, the retained direct data output unit 150 repetitively outputs a RAW1 code and a 1-byte direct data until the write pointer 102 reaches the 8-byte boundary or the end of the retained direct data (step S33), and returns to step S31.

On the other hand, when the write pointer 102 is present at the 8-byte boundary, the retained direct data output unit 150 determines whether or not the length of the retained direct data is equal to or greater than 8 bytes (step S34). As a result, when the length is equal to or greater than 8 bytes, the retained direct data output unit 150 repetitively outputs a RAW8 code and an 8-byte direct data until the rest of the retained direct data becomes less than 8 bytes (step S35). In contrast, when the length is not equal to or greater than 8 bytes, the retained direct data output unit 150 repetitively outputs a RAW1 code and a 1-byte direct data until reaching the end of the retained direct data (step S36). Then, the retained direct data output unit 150 returns to step S31.

Also, in outputting the RAW1 code and the RAW8 code, when the remaining capacity of the slide buffer is equal to or less than a predetermined amount, the retained direct data output unit 150 sets a drain bit d to 1 and outputs the RAW1 code and the RAW8 code.

As such, since the retained direct data output unit 150 outputs the retained direct data, the code string that is not searched from the slide buffer may be included in the compressed data, in a case where the matched code string is not searched from the slide buffer, like the early stage of the compression processing.

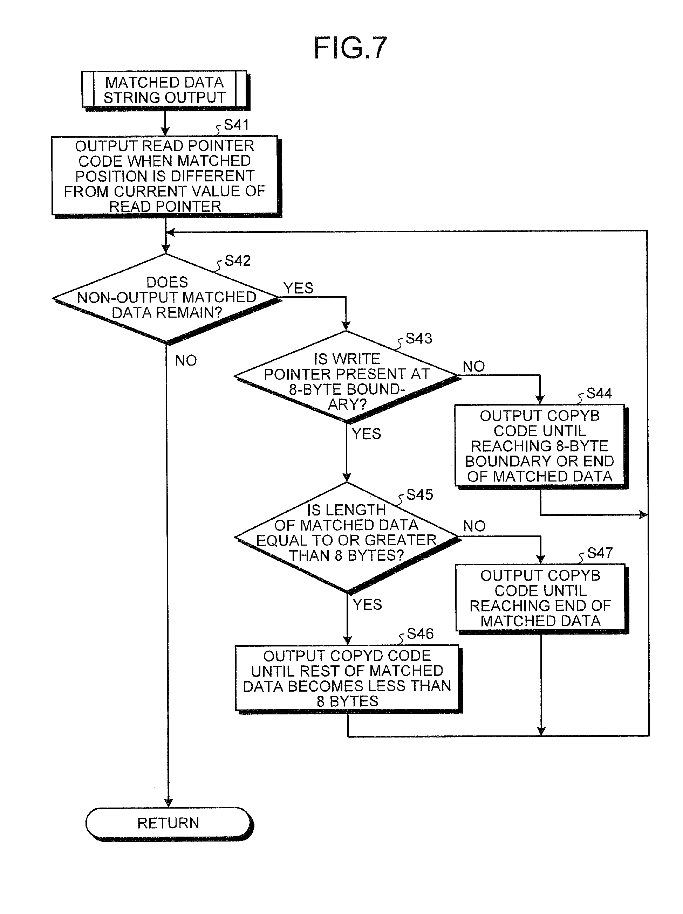

Next, the procedure of the matched data string output will be described. FIG. 7 is a flowchart illustrating the procedure of the matched data string output. As illustrated in FIG. 7, the matched data string output unit 160 outputs a read pointer code when a matched position of the code string within the slide buffer by the longest match string search is different from a current value of the read pointer (step S41).

Then, the matched data string output unit 160 determines whether or not non-output matched data remains (step S42). As a result, when the non-output matched data does not remain, the matched data string output unit 160 ends the processing.

On the other hand, when the non-output matched data remains, the matched data string output unit 160 determines whether or not the write pointer 102 is present at the 8-byte boundary (step S43). As a result, when the write pointer 102 is not present at the 8-byte boundary, the matched data string output unit 160 repetitively outputs a COPYB code until the write pointer 102 reaches the 8-byte boundary or the end of the matched data (step S44), and returns to step S42.

On the other hand, when the write pointer 102 is present at the 8-byte boundary, the matched data string output unit 160 determines whether or not the length of the matched data is equal to or greater than 8 bytes (step S45). As a result, when the length is equal to or greater than 8 bytes, the matched data string output unit 160 repetitively outputs a COPYD code until the rest of the matched data becomes less than 8 bytes (step S46). On the contrary, when the length is not equal to or greater than 8 bytes, the matched data string output unit 160 repetitively outputs a COPYB code until reaching the end of the matched data (step S47). Then, the matched data string output unit 160 returns to step S42.

Also, in outputting the COPYB code and the COPYD code, when the remaining capacity of the slide buffer is equal to or less than a predetermined amount, the matched data string output unit 160 sets a drain bit d to 1 and outputs the COPYB code and the COPYD code.

In this way, since the matched data string output unit 160 outputs the COPYB code and the COPYD code in correspondence to the matched data, the code strings repetitively appearing in the input data may be compressed.

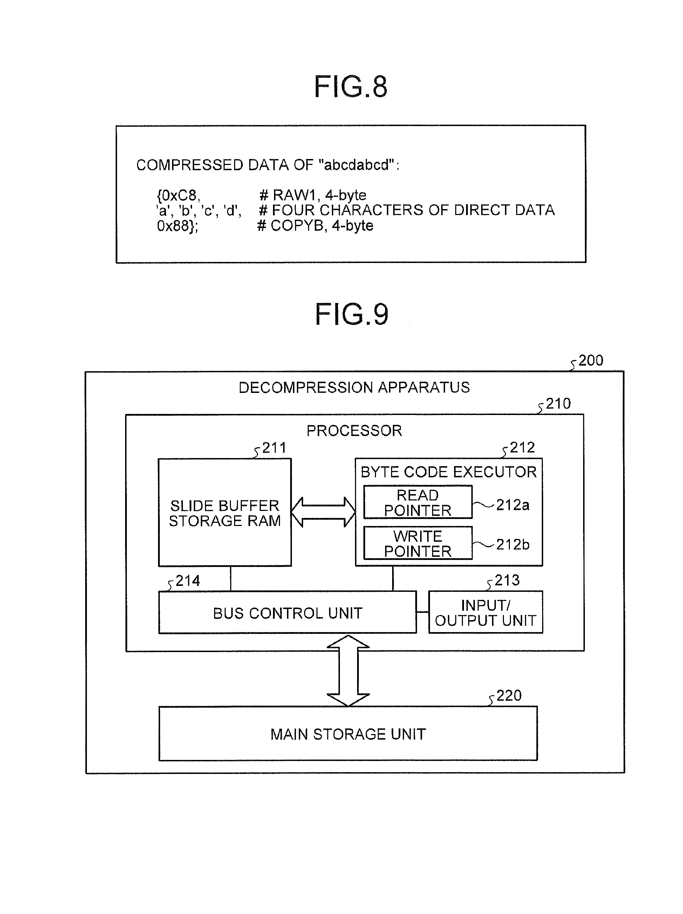

FIG. 8 is a diagram illustrating an example of compressed data. FIG. 8 illustrates compressed data in a case where a character string "abcdabcd" is compressed, and "0xXX" represents that "XX" is a hexadecimal number. In FIG. 8, "0xC8" represents the RAW1 code, a direct data length of which is 4 bytes, and 4-byte direct data "a", "b", "c" and "d" are stored in the slide buffer. A drain is not performed. Also, "0x88" represents the COPYB code, a length of which is 4 bytes, and a drain is not performed. Herein, since a copy has only to be performed from a position of read pointer = 0 by 4 bytes, a read pointer code is not output. Also, in each row, a character string after "#" is a comment.

Next, the configuration of the decompression apparatus 200 will be described. FIG. 9 is a diagram illustrating the configuration of the decompression apparatus 200. As illustrated in FIG. 9, the decompression apparatus 200 is a computer that includes a processor 210 and a main storage unit 220.

The processor 210 decompresses compressed data by executing byte codes, and the main storage unit 220 stores the compressed data and the decompressed data. The processor 210 includes a slide buffer storage RAM 211, a byte code executor 212, an input/output unit 213, and a bus control unit 214. The slide buffer storage RAM 211 is a memory that functions as a slide buffer. For example, the slide buffer storage RAM 211 has a capacity of 64K bytes.

The byte code executor 212 decompresses compressed data by reading byte codes from the main storage unit 220 through the bus control unit 214 and executing the read byte codes. The byte code executor 212 includes a read pointer 212a and a write pointer 212b. The byte code executor 212 accesses the slide buffer storage RAM 211 by using the read pointer 212a and the write pointer 212b. Also, when executing a byte code to which a drain is designated, the byte code executor 212 drains data stored in the slide buffer storage RAM 211 to the main storage unit.

The input/output unit 213 reads compressed data from a file, and stores the read compressed data in the main storage unit 220. Also, the input/output unit 213 reads the decompressed data from the main storage unit 220, and outputs the read decompressed data to the file.

The bus control unit 214 controls a bus that is used to read the byte codes from the main storage unit 220 by the byte code executor 212, and to drain data from the slide buffer storage RAM 211 to the main storage unit 220. Also, the bus control unit 214 controls a bus that is used for data transfer between the input/output unit 213 and the main storage unit 220.

As described above, in the first embodiment, the decompression of the compressed data is performed in a way that the compression apparatus 100 generates the byte code string as the compressed data, and the decompression apparatus 200 executes the byte codes. Therefore, the compression and decompression system may realize the compressed data decompression processing by the execution of instructions, and may perform the compression data decompression at a high speed.

### [b] Second Embodiment

In the first embodiment described above, the case where the decompression apparatus 200 is the computer executing the byte codes has been described. However, the decompression apparatus may also be realized by a main storage unit, a computer transmitting data in units of 8 bytes, and a program executed on the computer. Therefore, in the second embodiment, a case where the decompression apparatus is realized by a main storage unit, a computer transmitting data in units of 8 bytes, and a program executed on the computer will be described.

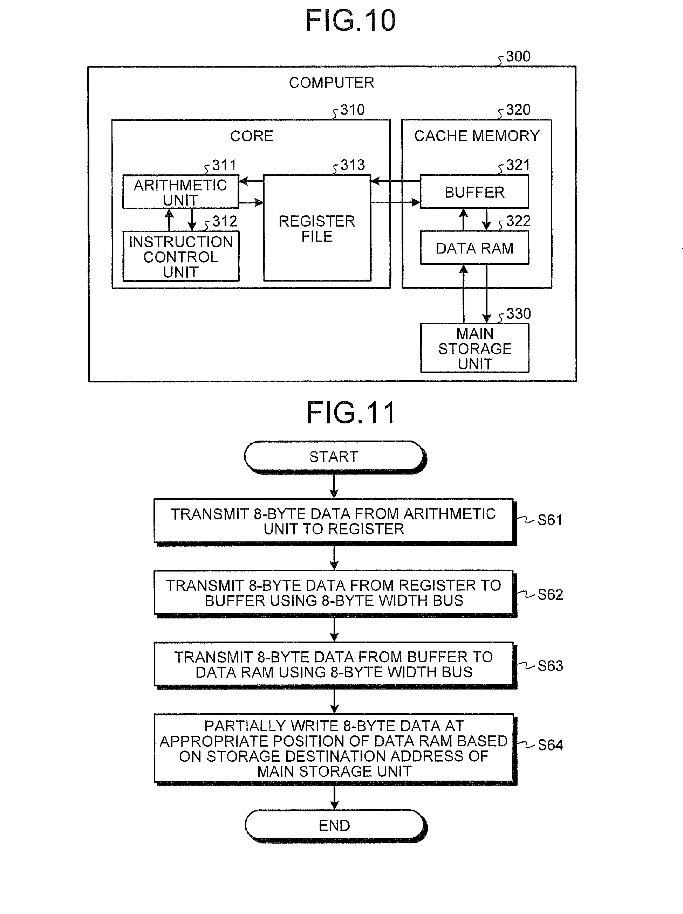

First, the computer used as the decompression apparatus will be described. FIG. 10 is a diagram illustrating the configuration of the computer used as the decompression apparatus. As illustrated in FIG. 10, the computer 300 used as the decompression apparatus includes a core 310, a cache memory 320, and a main storage unit 330.

The core 310 is a processing apparatus processing instructions, and includes an arithmetic unit 311, an instruction control unit 312, and a register file 313. The arithmetic unit 311 performs operations such as four arithmetic operations, logical operations, or the like, based on a direction from the instruction control unit 312. The instruction control unit 312 controls the core 310 and processes the instructions by using the arithmetic unit 311 and the register file 313. The register file 313 is a set of registers that store data used in the arithmetic unit 311 or operation results. The length of each register is 8 bytes.

The cache memory 320 is a memory for high-speed access to the main storage unit 330, and includes a buffer 321 and a data RAM 322. The buffer 321 temporarily stores data transmitted between the register file 313 and the data RAM 322. The length of the buffer 321 is 8 bytes, and data transmission between the register file 313 and the buffer 321 and data transmission between the buffer 321 and the data RAM 322 are based on 8 bytes.

The data RAM 322 stores a part of data stored in the main storage unit 330. Data transmission between the data RAM 322 and the main storage unit 330 is based on 64 bytes. The main storage unit 330 stores data used in the core 310, operation results in the core 310, and the like.

Next, the processing of the computer 300 in a case of writing 8-byte data to the main storage unit 330 will be described. FIG. 11 is a flowchart illustrating the processing of the computer 300 in the case of writing 8-byte data to the main storage unit 330.

As illustrated in FIG. 11, in the case of writing 8-byte data to the main storage unit 330, the 8-byte data is transmitted from the arithmetic unit 311 to a certain register of the register file 313 (step S61).

Then, the 8-byte data is transmitted from the register to the buffer 321 by using an 8-byte width bus (step S62). Then, the 8-byte data is transmitted from the buffer 321 to the data RAM 322 by using an 8-byte width bus (step S63).

Then, in the data RAM 322, the 8-byte data is partially written to an appropriate position, based on a storage destination address of the main storage unit 330 (step S64).

In this way, in the computer 300, the 8-byte-unit memory access is processed with the highest efficiency. On the contrary, the 1-byte-unit access is inefficient because valid data flows to only a part of the 8-byte width register and bus. Therefore, since the compression apparatus 100 generates the byte codes performing the copy of data in units of 8 bytes, the computer 300 may perform the decompression processing with high efficiency.

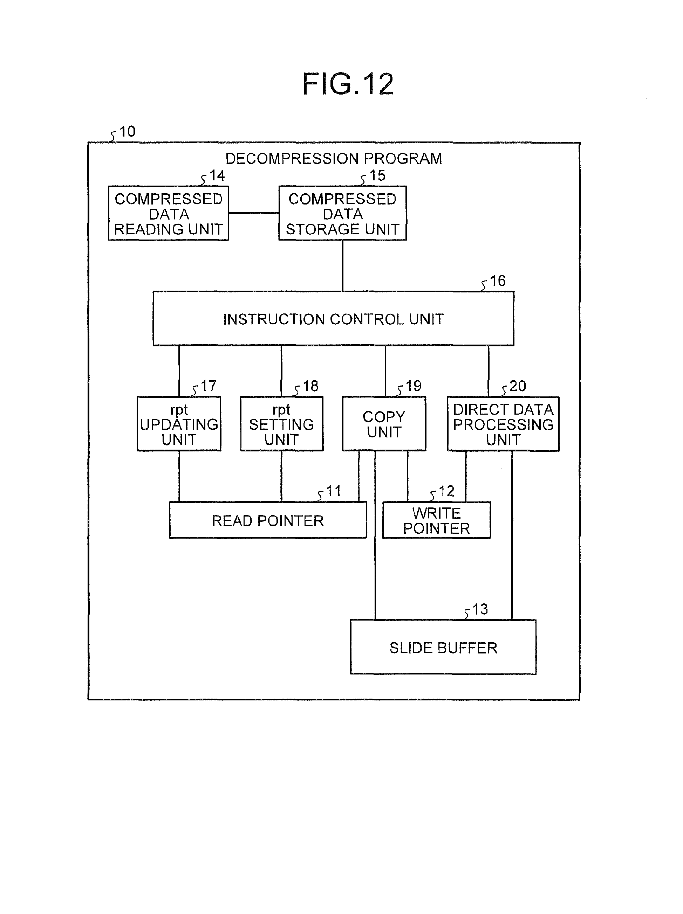

Next, a functional configuration of a decompression program will be described. FIG. 12 is a diagram illustrating the functional configuration of the decompression program. As illustrated in FIG. 12, a decompression program 10 includes a read-out pointer 11, a write pointer 12, a slide buffer 13, a compressed data reading unit 14, a compressed data storage unit 15, an instruction control unit 16, an rpt updating unit 17, an rpt setting unit 18, a copy unit 19, and a direct data processing unit 20.

The read pointer 11 designates a position where data is read from the slide buffer 13. The write pointer 12 designates a position where data is written to the slide buffer 13. The slide buffer 13 stores the decompressed data, decompressed based on the compressed data. The slide buffer 13 is an area on the main storage unit 330, and the size of the slide buffer 13 or the position on the main storage unit 330 are changed according to the decompression of data.

The compressed data reading unit 14 reads compressed data from a file, and writes the read compressed data to the compressed data storage unit 15. The compressed data storage unit 15 stores the compressed data. The instruction control unit 16 reads the compressed data from the compressed data storage unit 15, and controls the decompression processing. That is, the instruction control unit 16 sequentially reads the byte codes as the compressed data from the compressed data storage unit 15, determines the type of byte codes, and passes control to the processing unit according to the type.

The rpt updating unit 17 processes a byte code "read pointer update". That is, the rpt updating unit 17 adds bc[5:0] - 31 to the read pointer 11.

The rpt setting unit 18 processes a byte code "read pointer setup". That is, the rpt setting unit 18 sets a value, which has bc[5:0] of the first byte as upper 6 bits and bc[7:0] of the second byte as lower 8 bits, to the read pointer 11.

The copy unit 19 processes a byte code "drain & copy". That is, in the case of bc[5] = T = 0, the copy unit 19 copies, in the slide buffer 13, bytes of the number designated by bc[4:1] from a position designated by the read pointer 11, to a position designated by the write pointer 12. Also, in the case of bc[5] = T = 1, the copy unit 19 copies, in the slide buffer 13, double words of the number designated by bc[4:1] from a position designated by the read pointer 11, to a position designated by the write pointer 12. The copy unit 19 updates the read pointer 11 and the write pointer 12 with the copied byte number. Herein, since the slide buffer 13 is provided on the main storage unit 330, a drain is unnecessary.

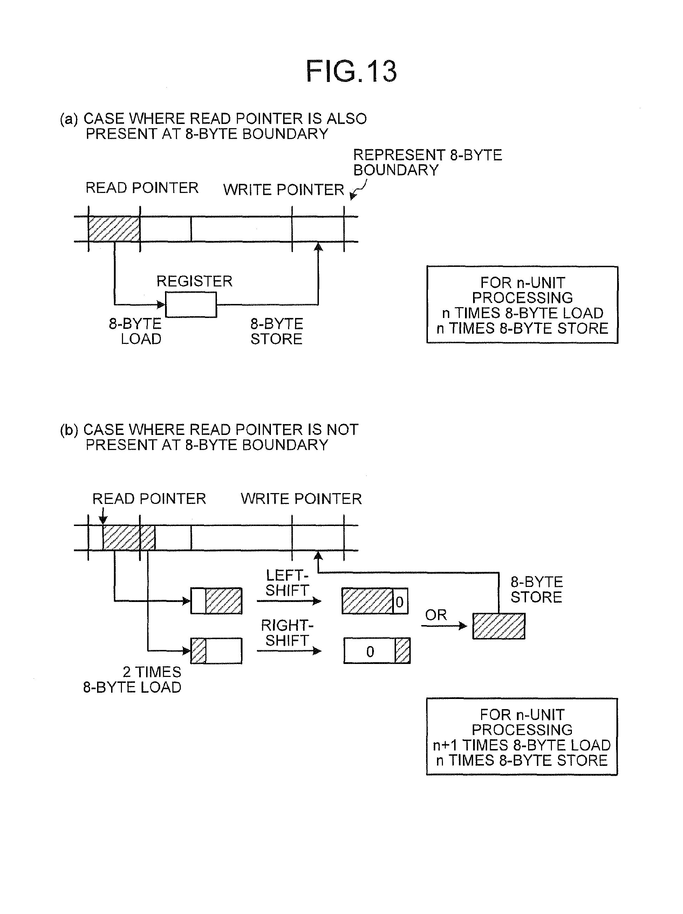

FIG. 13 is a diagram illustrating the number of times of load and store in an 8-byte-unit copy processing. FIG. 13(a) illustrates a case where the read pointer 11 is present at the 8-byte boundary of the main storage unit 330, and FIG. 13(b) illustrates a case where the read pointer 11 is not present at the 8-byte boundary of the main storage unit 330. Also, when the 8-byte-unit copy processing is performed, the compression apparatus 100 generates the byte code such that the write pointer 12 is always present at the 8-byte boundary of the main storage unit 330.

As illustrated in FIG. 13(a), in the case where the read pointer 11 is present at the 8-byte boundary of the main storage unit 330, the copy unit 19 loads 8 bytes on the register from the position indicated by the read pointer 11, and stores 8 bytes at the position indicated by the write pointer 12. Therefore, the number of times of executing instructions necessary for n-unit processing is n times 8-byte load instruction and n times 8-byte store instruction.

On the other hand, as illustrated in FIG. 13(b), in the case where the read pointer 11 is not present at the 8-byte boundary of the main storage unit 330, the copy unit 19 reads 16 bytes, including the 8 bytes of the copy target, from the main storage unit 330 to two registers by executing the 8-btye load instruction two times. The copy unit 19 left-shifts the register including the head of the copy target, such that the head of the copy target becomes the left extremity and 0 is filled from the right extremity, and right-shifts the register including the tail end of the copy target, such that the tail end of the copy target becomes the right extremity and 0 is filled from the left extremity. The copy unit 19 takes a logical addition of two registers, and stores 8 bytes at the position indicated by the write pointer 12.

Herein, next copy target data is included in the register including the tail end of the copy target. Therefore, when the register including the tail end of the copy target is right-shifted, the copy unit 19 shifts in the shift out data in a separate zero-cleared register and uses the register in the next copy. Therefore, in the next copy, the copy unit 19 may obtain the copy target data simply by loading 8 bytes including the tail end of the copy target on the register. That is, when the copy unit 19 performs the 8-byte-unit copy for n times, only the first copy needs the 8-btye load two times, and the other copies of (n-1) times need the 8-byte load only one time. Therefore, the number of times of executing instructions necessary for n-unit processing is n+1 times the 8-byte load instruction and n times the 8-byte store instruction. On the other hand, the number of times of executing the instruction, when the n-unit processing is performed in units of 1 byte, is 8n times the load instruction and 8n times the store instruction.

Therefore, even when the read pointer 11 indicates a position other than the 8-byte boundary of the main storage unit 330, the copy unit 19 performs the 8-byte-unit copy to reduce the number of times of executing the load instruction and the store instruction in comparison with a case of executing the 1-byte-unit copy.

The direct data processing unit 20 processes a byte code "drain & direct data". That is, in a case of be[5] = T = 0, the direct data processing unit 20 stores bytes of the number designated by bc[4:1] from next byte of the compressed data, in a position designated by the write pointer 12 in the slide buffer 13. Also, in a case of bc[5] = T = 1, the direct data processing unit 20 stores double words of the number designated by bc[4:1] from next double words of the compressed data, in a position designated by the write pointer 12 in the slide buffer 13. The direct data processing unit 20 updates the byte number written in the write pointer 12. Herein, since the slide buffer 13 is provided in the main storage unit 330, a drain is unnecessary.

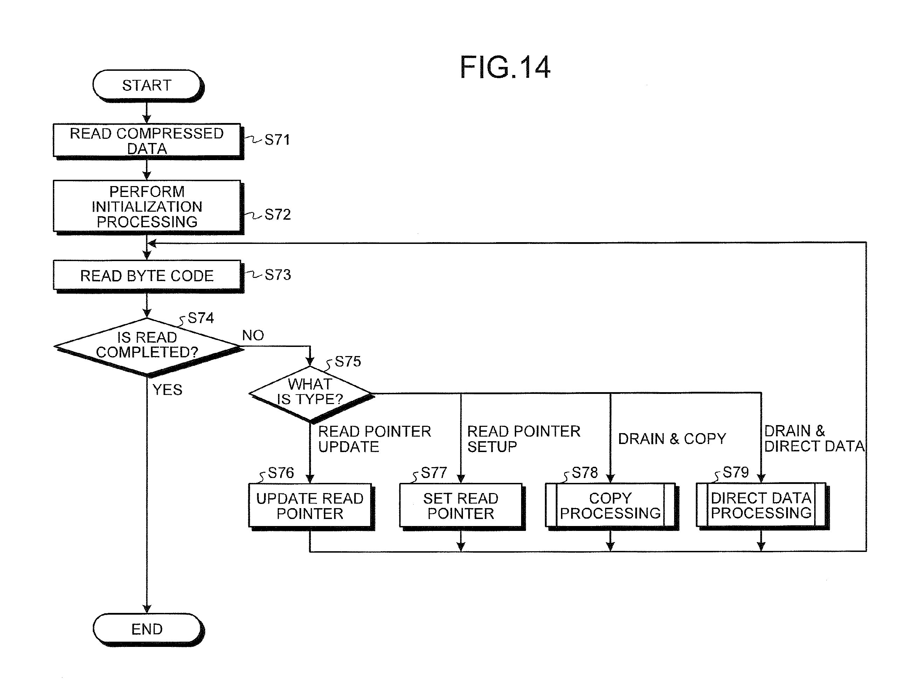

Next, the procedure of the decompression processing by the decompression program 10 will be described. FIG. 14 is a flowchart illustrating the procedure of the decompression processing by the decompression program 10. As illustrated in FIG. 14, in the decompression program 10, the compressed data reading unit 14 reads compressed data from a file (step S71), and writes the read data to the compressed data storage unit 15.

Then, the instruction control unit 16 performs an initialization processing necessary to execute the byte codes (step S72). As the initialization processing, there is an initial setting of the read pointer 11, the write pointer 12, and the slide buffer 13, or the like.

Then, the instruction control unit 16 reads a byte code from the compressed data storage unit 15 (step S73), and determines whether or not the reading of all byte codes is completed (step S74). As a result, when the reading of all byte codes is completed, the instruction control unit 16 ends the decompression processing.

On the other hand, when the reading of all byte codes is not completed, the instruction control unit 16 determines the type of the read byte code (step S75). As a result, when the byte code is a "read pointer update", the rpt updating unit 17 updates the read pointer 11 (step S76). Also, when the byte code is a "read pointer setup", the rpt setting unit 18 sets a value to the read pointer 11 (step S77). Also, when the byte code is a "drain & copy", the copy unit 19 performs the copy processing (step S78). Also, when the byte code is a "drain & direct data", the direct data processing unit 20 performs the direct data processing (step S79).

Then, the instruction control unit 16 returns to step S73 to process the next byte code. In this way, since the instruction control unit 16 performs the processing based on the type of each of the byte codes, the decompression program 10 may decompress the compressed data.

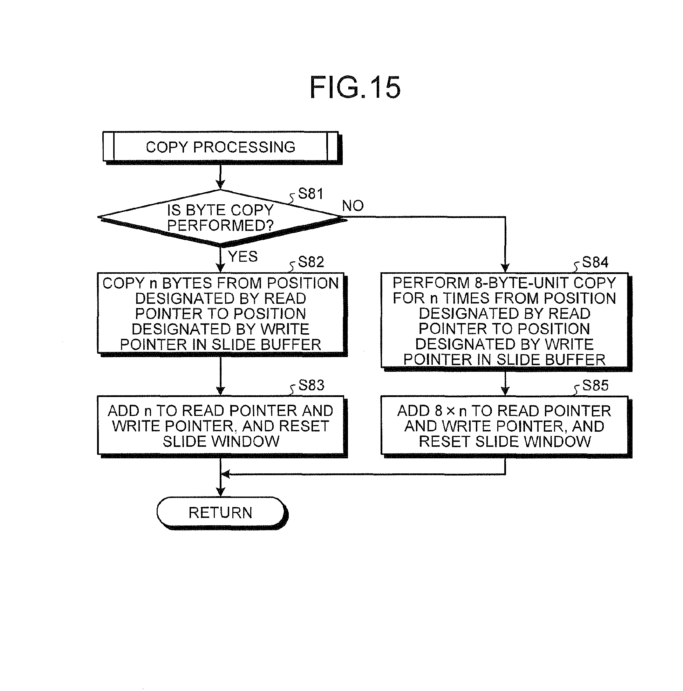

Next, the procedure of the copy processing will be described. FIG. 15 is a flowchart illustrating the procedure of the copy processing. As illustrated in FIG. 15, the copy unit 19 determines whether it is the byte copy, that is, whether a value of bc[5] = T is 0 or 1 (step S81).

As a result, when it is determined as being the byte copy, the copy unit 19 copies, in the slide buffer 13, n bytes from a position designated by the read pointer 11 to a position designated by the write pointer 12 (step S82). Herein, n is the number designated by bc[4:1]. Then, the copy unit 19 adds n to the read pointer 11 and the write pointer 12, and resets the slide window (step S83).

On the other hand, when it is determined as not being the byte copy, the copy unit 19 performs, in the slide buffer 13, the 8-byte-unit copy for n times from a position designated by the read pointer 11 to a position designated by the write pointer 12 (step S84). Then, the copy unit 19 adds 8 x n to the read pointer 11 and the write pointer 12, and resets the slide window (step S85).

In this way, since the copy unit 19 copies data from the position designated by the read pointer 11 to the position designated by the write pointer 12, the decompressed data may be generated within the slide buffer 13.

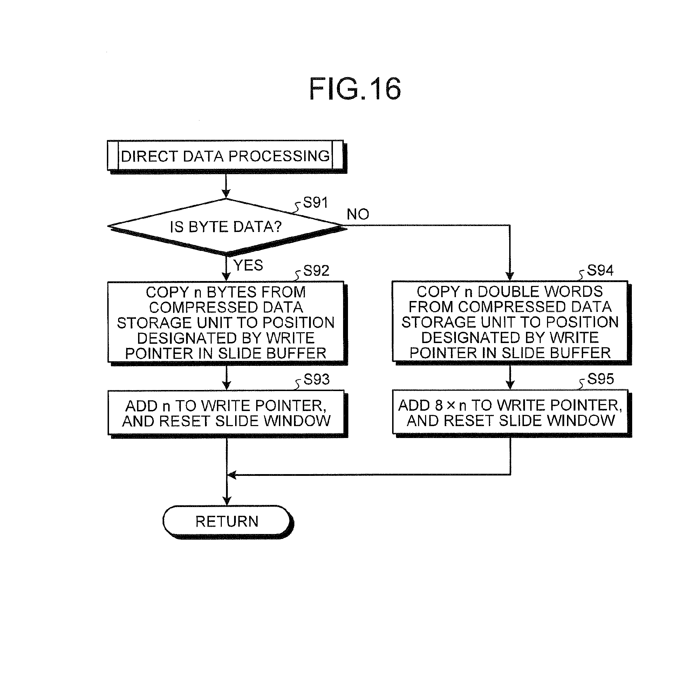

Next, the procedure of the direct data processing will be described. FIG. 16 is a flowchart illustrating the procedure of the direct data processing. As illustrated in FIG. 16, the direct data processing unit 20 determines whether the direct data is the byte data, that is, whether a value of bc[5] = T is 0 or 1 (step S91).

As a result, when it is determined that the direct data is the byte copy, the direct data processing unit 20 copies n bytes from the compressed data storage unit 15 at a position designated by the write pointer 12 in the slide buffer 13 (step S92). Herein, n is the number designated by bc[4:1]. Then, the direct data processing unit 20 adds n to the write pointer 12, and resets the slide window (step S93).

On the other hand, when it is determined that the direct data is not the byte data, the direct data processing unit 20 copies n double words from the compressed data storage unit 15 at a position designated by the write pointer 12 in the slide buffer 13 (step S94). Then, the direct data processing unit 20 adds 8 x n to the write pointer 12, and resets the slide window (step S95).

In this way, since the direct data processing unit 20 copies data from the compressed data storage unit 15 to the position designated by the write pointer 12, the decompressed data may be generated in the slide buffer 13.

As described above, in the second embodiment, the decompression program 10 analyzes and executes the byte codes and performs the decompression of the compressed data, the compression apparatus 100 may set the byte codes as the compressed data.

Also, in the first and second embodiments, the compression apparatus 100 has been described. However, the compression program having the same functions may be obtained by realizing the configuration of the compression apparatus 100 by software. Therefore, the computer executing the compression program will be described.

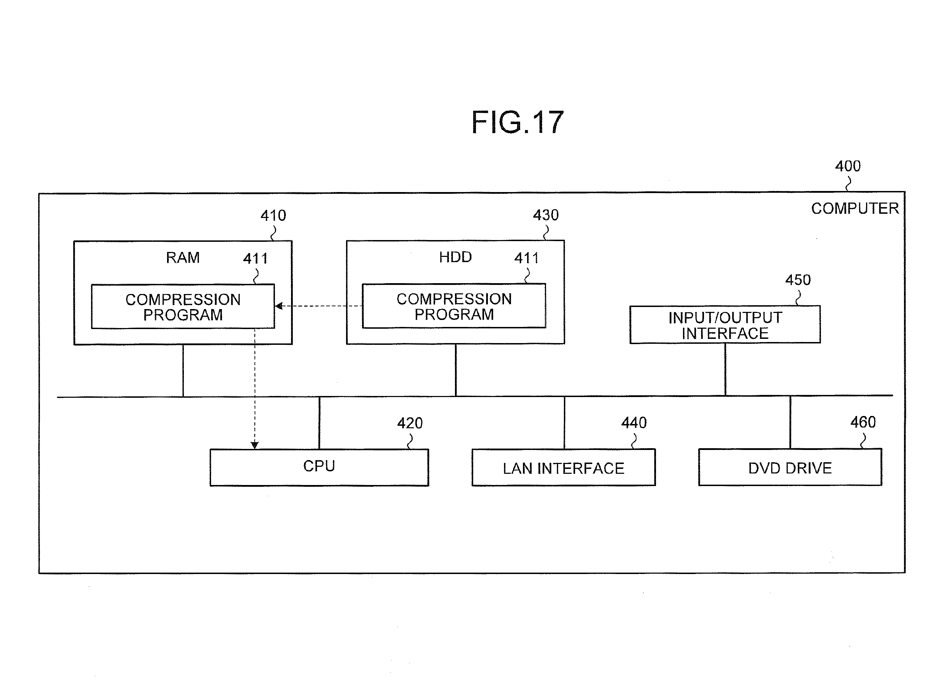

FIG. 17 is a functional block diagram illustrating the configuration of the computer executing the compression program according to the embodiment. As illustrated in FIG. 17, a computer 400 includes a RAM 410, a CPU 420, an HDD 430, a LAN interface 440, an input/output interface 450, and a DVD drive 460.

The RAM 410 is a memory that stores a program or an intermediate execution result of the program, and the CPU 420 is a central processing unit that reads and executes the program from the RAM 410. The HDD 430 is a disk device that stores the program or data, and the LAN interface 440 is an interface that connects the computer 400 to other computer through a LAN. The input/output interface 450 is an interface that connects an input device, such as a mouse or a keyboard, and a display device, and the DVD drive 460 is a device that performs read from and write to a DVD.

A compression program 411 executed on the computer 400 is stored in the DVD, is read from the DVD by the DVD drive 460, and is installed in the computer 400. Alternatively, the compression programs 411 is stored in databases or the like of other computer system connected through the LAN interface 440, is read from the databases, and is installed in the computer 400. The installed compression program 411 is stored in the HDD 430, is read in the RAM 410, and is executed by the CPU 420. Also, the computer 400 can also execute the decompression program 10.

Also, in the first and second embodiments, the case where the compression and decompression system uses the byte codes has been described. However, the present invention is not limited to this, and may also be equally applied when the compression and decompression system uses the data of a format, which designates the processing in the decompression, such as whether to copy data in units of bytes or copy data in units of 8 bytes, as the compressed data.

Also, in the first and second embodiments, the case where the data transmission within the computer executing the decompression processing is performed in units of 8 bytes has been described. However, the present invention is not limited to this, and may also be equally applied when the data transmission is performed in units other than 8 bytes, for example, in units of 16 bytes.

## Claims

1. A compression and decompression system comprising:
a compression apparatus (100) that generates compressed data, which includes a code string capable of generating data by execution, based on the compressed data obtained by compressing the data, and has a small data amount with respect to the data; and
a decompression apparatus (200) that generates the data by executing the code string included in the compressed data.

2. The compression and decompression system according to claim 1, wherein the compression apparatus (100) determines whether a processing instruction of data having multiple times a unit length is used or a processing instruction of data having a unit length is used upon decompression, and generates the code string based on a determination result, and
the decompression apparatus (200) executes a code string which includes a processing instruction of data having multiple times the unit length and a processing instruction of data having the unit length.

3. The compression and decompression system according to claim 2, wherein the compression apparatus (100) generates, as instructions included in the code string, a pointer operation instruction operating a read pointer indicating a read position of a slide buffer storing a part of the data while moving a range storing decompressed data, a copy instruction copying data of a designated length from a position indicated by the read pointer to a position indicated by a write pointer in a slide buffer, and a direct data processing instruction copying designated data within the instruction to a position indicated by a write pointer in the slide buffer, and
the decompression apparatus (200) executes a code string which includes the pointer operation instruction, the copy instruction, and the direct data processing instruction.

4. The compression and decompression system according to claim 3, wherein the decompression apparatus includes a storage unit different from the slide buffer, and
the compression apparatus (100) determines whether data having the same length as copied data is drained from the slide buffer to the storage unit, and designates a determination result by the copy instruction and the direct data processing instruction.

5. The compression and decompression system according to claim 3, wherein before the compression apparatus (100) generates the processing instruction of data having multiple times the unit length, the compression apparatus (100) generates a processing instruction of data having a unit length, such that a value of the write pointer is multiple times the unit length.

6. A compression apparatus (100) for generating compressed data by compressing data, the compression apparatus comprising
a generation unit that generates compressed data which includes a code string capable of generating the data by execution, based on the compressed data obtained by compressing the data, and has a small data amount with respect to the data.

7. A decompression apparatus (200) for decompressing compressed data, which is data compressed by a compression apparatus, the decompression apparatus comprising
a decompression unit that generates the data by executing a code string included in compressed data having a small data amount with respect to the data.

8. A compression and decompression method comprising:
generating compressed data, which includes a code string capable of generating data by execution, based on the compressed data obtained by compressing the data, and has a small data amount with respect to the data; and
generating the data by executing the code string included in the compressed data.

9. A computer-readable storage medium having stored therein a compression program, the compression program causing a computer to execute a process comprising:
generating compressed data, which includes a code string capable of generating data by execution, based on the compressed data obtained by compressing the data, and has a small data amount with respect to the data.

10. A computer-readable storage medium having stored therein a decompression program, the decompression program causing a computer to execute a process comprising:
generating the data by executing a code string that is included in compressed data having a small data amount with respect to the data.
